# EUROPEAN PATENT APPLICATION

(11) **EP 4 642 172 A1**
(43) Date of publication of application: **29.10.2025**
(21) Application number: 24886033.0
(22) Date of filing: 24.09.2024
(51) Int. Cl.: H05K 1/14, H01M 50/51, H01M 10/42, H01M 50/284

(54) **PRINTED CIRCUIT BOARD AND BATTERY SYSTEM USING SAME**

(30) Priority: 03.11.2023 KR 20230150972
(71) Applicant: LG Energy Solution, Ltd., Seoul 07335 (KR)
(72) Inventor: KIM, Kyeongmin, Daejeon 34122 (KR); CHOI, Jang Hyeok, Daejeon 34122 (KR)
(74) Representative: Plasseraud IP
(86) International application number: PCT/KR2024/014354
(87) International publication number: WO 2025/095355

(57) **Abstract**

Provided are a printed circuit board and a battery system using the same. The printed circuit board includes: a plurality of battery monitoring integrated circuit (BMIC) mounting circuits, each providing an electrical connection for its corresponding plurality of battery cells; and a connection module providing electrical connections among the first BMIC mounting circuit disposed at one outermost side of the plurality of BMIC mounting circuits, the second BMIC mounting circuit adjacent to the first BMIC mounting circuit, and a first connection terminal, wherein the first connection terminal is connected to a master battery management system (MBMS), the connection module provides the connection between the second BMIC mounting circuit and the first connection terminal when the BMIC is not electrically connected to the first BMIC mounting circuit, and the connection module provides the connections between the first connection terminal and the first BMIC mounting circuit and between the first BMIC mounting circuit and the second BMIC mounting circuit when the BMIC is electrically connected to the first BMIC mounting circuit.

## Description

### [Technical Field]

### CROSS-REFERENCE TO RELATED APPLICATION

This application claims priority to and the benefit of Korean Patent Application No. 10-2023-0150972 filed in the Korean Intellectual Property Office on November 3, 2023, the entire contents of which are incorporated herein by reference.

The present disclosure relates to a printed circuit board and a battery system using the same.

### [Background Art]

The battery system may include a plurality of cell module controllers (CMCs) that each measure information of each battery module and a master battery management system (BMS) that controls the plurality of CMCs.

Each of the plurality of CMCs may include a plurality of battery monitoring integrated circuits (BMICs), and each BMIC may be connected to each corresponding battery module to thus measure information of the battery module, for example, a cell voltage, a module voltage, or a module temperature. However, the number of BMICs included in each of the plurality of CMCs may not be constant depending on the number of battery modules. The plurality of CMCs including different numbers of BMICs may have different layouts.

### [Disclosure]

### [Technical Problem]

The present disclosure attempts to provide a printed circuit board that includes a cell module controller (CMC) capable of including different numbers of battery monitoring integrated circuits (BMICs), and a battery system that includes the plurality of CMCs and enables communication between the plurality of CMCs capable of including different numbers of BMICs and a master battery management system (BMS).

### [Technical Solution]

According to one aspect, provided is a printed circuit board (PCB) including: a plurality of battery monitoring integrated circuit (BMIC) mounting circuits, each providing an electrical connection for its corresponding plurality of battery cells; and a connection module providing electrical connections among a first BMIC mounting circuit disposed at one outermost side of the plurality of BMIC mounting circuits, a second BMIC mounting circuit adjacent to the first BMIC mounting circuit, and a first connection terminal, wherein the first connection terminal is connected to a master battery management system (MBMS), the connection module provides the connection between the second BMIC mounting circuit and the first connection terminal when a BMIC is not electrically connected to the first BMIC mounting circuit, and the connection module provides the connections between the first connection terminal and the first BMIC mounting circuit and between the first BMIC mounting circuit and the second BMIC mounting circuit when a BMIC is electrically connected to the first BMIC mounting circuit.

The connection module may include a first resistor mounting circuit having one end connected to a first terminal connected to the second BMIC mounting circuit via a first wiring, and the other end connected to a second terminal connected to the first BMIC mounting circuit via a second wiring, and a second resistor mounting circuit having one end connected to a third terminal connected to the first BMIC mounting circuit via a third wiring, and the other end connected to a fourth terminal connected to the first connection terminal via a fourth wiring.

A resistor may be electrically connected between the one end and the other end of the first resistor mounting circuit, and when the resistor is electrically connected between the one end and the other end of the second resistor mounting circuit, the connection module may provide electrical connections between the first terminal and the second terminal and between the third terminal and the fourth terminal.

The connection module may further include a third resistor mounting circuit having one end connected to the first terminal and the other end connected to the fourth terminal.

A resistor is electrically connected between the one end and the other end of the third resistor mounting circuit, the connection module may provide an electrical connection between the first terminal and the fourth terminal.

When no resistor is electrically connected between the one end and the other end of each of the first to third resistor mounting circuits, each of the first to third resistor mounting circuits may be open between its one end and the other end.

According to another aspect, provided is a battery system including: a plurality of battery modules connected in series; a plurality of cell module controllers (CMCs) connected to the plurality of battery modules; and a master battery management system (MBMS) communicating with the plurality of CMCs in a daisy chain manner wherein each of the plurality of CMCs includes a first connection terminal connected to the MBMS, a plurality of battery monitoring integrated circuits (BMICs) each connected to each of the plurality of battery modules corresponding to the plurality of battery modules, a first BMIC mounting circuit connected to the battery module disposed at one outermost side of the plurality of battery modules corresponding to the plurality of battery modules, a second BMIC mounting circuit adjacent to the first BMIC mounting circuit and providing an electrical connection between its corresponding plurality of battery cells and a corresponding BMIC among the plurality of BMICs, and a connection module providing electrical connections among the first BMIC mounting circuit, the second BMIC mounting circuit, and the MBMS, the connection module provides a connection between the second BMIC mounting circuit and the MBMS when a BMIC is not electrically connected to the first BMIC mounting circuit, and the connection module provides connections between the MBMS and the first BMIC mounting circuit and between the first BMIC mounting circuit and the second BMIC mounting circuit when a BMIC is electrically connected to the first BMIC mounting circuit.

The connection module may include a first resistor mounting circuit having one end connected to a first terminal connected to the second BMIC mounting circuit via a first wiring, and the other end connected to a second terminal connected to the first BMIC mounting circuit via a second wiring, and a second resistor mounting circuit having one end connected to a third terminal connected to the first BMIC mounting circuit via a third wiring, and the other end connected to a fourth terminal connected to the first connection terminal via a fourth wiring.

Wherein a resistor may be electrically connected between the one end and the other end of the first resistor mounting circuit, and when the resistor is electrically connected between the one end and the other end of the second resistor mounting circuit, the connection module may provide electrical connections between the first terminal and the second terminal and between the third terminal and the fourth terminal.

The connection module may further include a third resistor mounting circuit having one end connected to the first terminal and the other end connected to the fourth terminal.

When a resistor is electrically connected between the one end and the other end of the third resistor mounting circuit, the connection module may provide an electrical connection between the first terminal and the fourth terminal.

When no resistor is electrically connected between the one end and the other end of each of the first to third resistor mounting circuits, each of the first to third resistor mounting circuits may be open between its one end and the other end.

### [Advantageous Effects]

As set for the above, the present disclosure may provide the battery system including the plurality of CMCs having the fewer types of layouts.

The present disclosure may provide the communication connection structure between the plurality of BMICs and the master BMS for the CMCs including the different numbers of BMICs inside.

The present disclosure may provide the communication connection structure in which the last BMIC of each CMC may communicate with the next CMC or the master battery management system (BMS) even when the plurality of CMCs having the same layout include the different numbers of BMICs.

According to the present disclosure, the plurality of CMCs including the different numbers of BMICs may not necessarily involve the layout changes due to the differences in the number of BMICs, and thus be disposed on the battery circuit in the various configuration types.

According to the present disclosure, the number of master data management (MDMs) to be managed may be reduced based on the various CMC configuration types, thereby improving management efficiency.

According to the present disclosure, the plurality of CMCs may have the same layout. Therefore, compared to the circuit requiring the different layouts based on the difference in the number of BMICs while each CMC performs the same function for each internal BMIC, the types of CMC layouts on the single battery circuit may also be reduced, thereby reducing the number of components to be managed, which may facilitate the circuit management.

The present disclosure may be advantageous in terms of the management by maintaining the same PCB management and changing the mounting location of the BMIC.

### [Description of the Drawings]

FIG. 1 is a block diagram schematically showing a battery system according to an embodiment.
FIG. 2 is a block diagram schematically showing a board of one of two cell module controllers (CMCs) shown in FIG. 1.
FIG. 3 is a block diagram schematically showing a detailed configuration of one of two connection modules shown in FIG. 1.
FIG. 4 is a block diagram showing a state where resistors are mounted on two of a plurality of resistor mounting circuits shown in FIG. 3.
FIG. 5 is a block diagram schematically showing a detailed configuration of the connection module connected to a battery monitoring integrated circuit (BMIC) mounting circuit not having the BMIC mounted thereon among the connection module shown in FIG. 1.
FIG. 6 is a block diagram showing a state where the resistor is mounted on one of the plurality of resistor mounting circuits shown in FIG. 5.
FIG. 7 is an example diagram of a comparison circuit not including the connection module.

### [Mode for Invention]

Hereinafter, embodiments of the present disclosure are described in detail with reference to the accompanying drawings, the same or similar components are denoted by the same or similar reference numerals, and an overlapping description thereof is omitted. Terms "module" and/or "unit" for components described in the following description are used only to make the specification easily understood. Therefore, these terms do not have meanings or roles distinguished from each other in themselves. Further, in describing the embodiments of the present disclosure, omitted is a detailed description of a case where it is decided that the detailed description of the known art related to the present disclosure may obscure the gist. Furthermore, it should be understood that the accompanying drawings are provided only to allow the embodiments of the present disclosure to be easily understood, and the spirit of the present disclosure is not limited to the accompanying drawings and includes all the modifications, equivalents, and substitutions included in the spirit and scope of the present disclosure.

Terms including ordinal numbers such as "first" and "second" may be used to describe various components. However, these components are not limited to these terms. These terms are used only to distinguish one component and another component from each other.

It should be further understood that the terms such as "include" and "have", used in this application specify the presence of features, numerals, steps, operations, components, parts, or combinations thereof, mentioned in the specification, and do not preclude the presence or addition of one or more other features, numerals, steps, operations, components, parts, or combinations thereof.

A program implemented as a set of instructions embodying a control algorithm necessary to control another configuration may be installed in a configuration for controlling another configuration under a specific control condition among configurations according to an embodiment. The control configuration may generate output data by processing input data and stored data based on the installed program. The control configuration may include a nonvolatile memory that stores the program and a memory that stores the data.

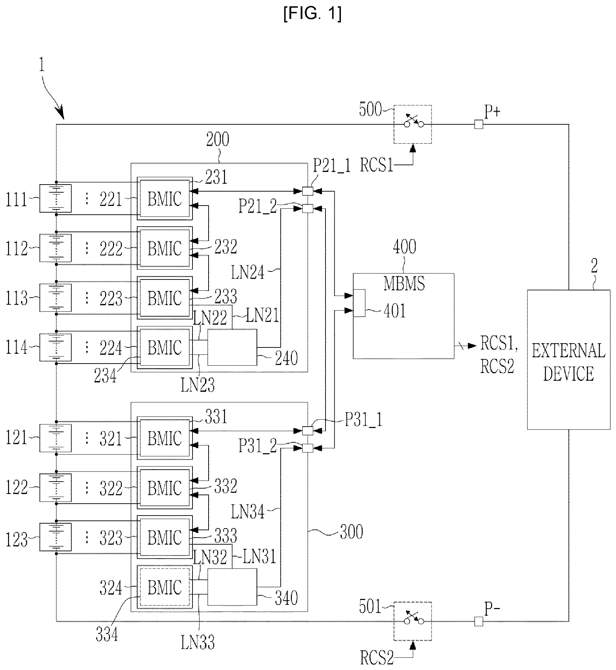

FIG. 1 is a block diagram schematically showing a battery system according to an embodiment.

Referring to FIG. 1, a battery system 1 may include a plurality of battery modules 111 to 114 and 121 to 123, a plurality of cell module controllers (CMCs) 200 and 300, a master battery management system (MBMS) 400, and relays 500 and 501.

The plurality of battery modules 111 to 114 and 121 to 123 may each be implemented as two or more battery cells connected in series, the plurality of battery cells including two or more battery cells connected in parallel and connected in series or two or more battery cells connected in parallel. Hereinafter, for convenience of description, it is assumed that the plurality of battery modules 111 to 114 and 121 to 123 each include the two or more battery cells connected in series.

The relay 500 or 501 may have one end connected to the plurality of battery modules 111 to 114 or 121 to 123, and the other end connected to at least one component of an external device 2. Closing and opening of the relay 500 or 501 may be controlled based on a relay control signal RCS1 or RCS2 supplied from the MBMS 400.

The battery system 1 may be connected to the external device 2. The external device 2 may include a loading or charging device such as an inverter or a converter. When the external device 2 is a charger, both ends P+ and P-of the battery system 1 may be connected to the charger and supplied with power from the charger to be charged. When the external device 2 is a load, both the ends P+ and P- of the battery system 1 may be connected to the load, and power supplied by a battery pack 10 may thus be discharged through the load.

The MBMS 400 may measure the voltage, current, insulation resistance, or the like of each of the plurality of battery modules 111 to 114 and 121 to 123, or perform a control operation required for the measurement. The MBMS 400 may be connected to and communicate with the plurality of CMCs 200 and 300 in a daisy chain manner. For example, the MBMS 400 may communicate with the plurality of CMCs 200 and 300 via an isolated serial peripheral interface (ISO-SPI).

The plurality of CMCs 200 and 300 may each measure information of the plurality of battery modules 111 to 114 and 121 to 123 and transmit the information to the MBMS 400. The information of the plurality of battery modules 111 to 114 and 121 to 123 may include a cell voltage of each battery cell disposed in the plurality of battery modules 111 to 114 and 121 to 123, a voltage across each module, the module temperature, or the like.

Each of the plurality of CMCs 200 and 300 may be implemented on a printed circuit board (PCB). Each of the plurality of CMCs 200 and 300 may include a plurality of battery monitoring integrated circuits (BMICs). Each of the plurality of CMCs 200 and 300 may be considered as a slave BMS in its relationship with the MBMS 400. The following description of the plurality of CMCs 200 and 300 may also be considered as a description of the printed circuit board on which each of the plurality of CMCs 200 and 300 is implemented.

FIG. 1 shows that the number of the plurality of CMCs 200 and 300 is two, which is described for the convenience of description, and the present disclosure is not limited thereto. The battery system 1 may include two or more CMCs.

In addition, FIG. 1 shows that the number of the plurality of battery modules 111 to 114 and 121 to 123 is seven battery modules, and among these battery modules, the number of the battery modules 111 to 114 connected to the CMC 200 is four, and the number of the battery modules 121 to 123 connected to the CMC 300 is three, which is described for the convenience of description, and the present disclosure is not limited thereto. The battery system 1 may include four or more battery modules, and each of the plurality of CMCs may be connected to two or more battery modules.

The CMC 200 may include two terminals P21_1 and P21_2, a plurality of BMIC mounting circuits 221 to 224, a plurality of BMICs 231 to 234, a connection module 240, and a plurality of wirings LN21 to LN24. The plurality of BMIC mounting circuits 221 to 224 may indicate the plurality of circuits including a plurality of vias formed to mount the respective BMICs and the plurality of terminals connected to the plurality of battery cells. The two terminals P21_1 and P21_2 may be terminals formed to allow the CMC 200 to be connected to the MBMS 300 and at least one remaining CMC 300 among the plurality of CMCs 200 and 300 in the daisy chain manner.

Hereinafter, the number of the plurality of BMIC mounting circuits 221 to 224 is described as being four, which is described only for the convenience of description, and the present disclosure is not limited thereto. The CMC 200 may include the plurality of BMIC mounting circuits depending on the number of corresponding modules 111 to 114 among the plurality of battery modules 111 to 114 and 121 to 123.

Each of the plurality of BMIC mounting circuits 221 to 224 (e.g., circuit 221) may have its corresponding BMIC (e.g., BMIC 231) among the plurality of BMICs 231 to 234. Each of the plurality of BMIC mounting circuits 221 to 224 (e.g., circuit 221) may provide an electrical connection between the plurality of battery cells included in its corresponding battery module (e.g., module 111) among the plurality of battery modules 111 to 114 and its corresponding BMIC (e.g., BMIC 231) among the plurality of BMICs 231 to 234. When the plurality of BMICs 231 to 234 are electrically connected to the plurality of BMIC mounting circuits 221 to 224, each of the plurality of BMICs 231 to 234 (e.g., BMIC 231) may be connected to both ends of its corresponding battery module 111 among the plurality of battery modules 111 to 114. In detail, each of the plurality of BMICs 231 to 234 (e.g., BMIC 231) may be connected to both ends of the plurality of battery cells included in its corresponding battery module 111.

The plurality of BMIC mounting circuits 221 to 224 may be connected with each other in the daisy chain manner. The BMIC mounting circuit 221 may be electrically connected to the terminal P21_1 and electrically connected to the BMIC mounting circuit 222. The BMIC mounting circuit 222 may be electrically connected to the BMIC mounting circuit 223. The BMIC mounting circuit 223 may be electrically connected to the connection module 240 via the wiring LN21. The BMIC mounting circuit 224 may be electrically connected to the connection module 240 via the wiring LN21 and the wiring LN23. The connection module 240 may be electrically connected to the terminal P21_2 via the wiring LN24. The wirings formed inside the CMC 200, described below, may be implemented as an internal wiring (trace) on the board on which the CMC 200 is implemented.

Each of the plurality of BMICs 231 to 234 (e.g., BMIC 231) may be connected to both the ends of the plurality of battery cells included in its corresponding battery module (e.g., module 111) among the plurality of battery modules 111 to 114. The BMIC 231 may receive a signal indicating the voltage across each of the plurality of battery cells included in the battery module 111, and derive the cell voltage of each of the plurality of battery cells included in the battery module 111. The BMIC 232 may receive a signal indicating the voltage across each of the plurality of battery cells included in the battery module 112, and derive the cell voltage of each of the plurality of battery cells included in the battery module 112. The BMIC 233 may receive a signal indicating the voltage across each of the plurality of battery cells included in the battery module 113, and derive the cell voltage of each of the plurality of battery cells included in the battery module 113. The BMIC 234 may receive a signal indicating the voltage across each of the plurality of battery cells included in the battery module 114, and derive the cell voltage of each of the plurality of battery cells included in the battery module 114.

The plurality of BMIC 231 to 233 may be connected with each other in the daisy chain manner. The BMIC 231 disposed at one end of the plurality of BMICs 231 to 233 may communicate with the terminal P21_1 to thus transmit and receive the signals and/or data. The BMIC 231 may communicate with the BMIC 232 to thus transmit and receive the signal and/or the data. The BMIC 232 may communicate with the BMIC 233 to thus transmit and receive the signal and/or the data. The BMIC 233 may communicate with the BMIC 234 to thus transmit and receive the signal and/or the data.

The mounting circuit (e.g., circuit 224) disposed at one outermost side of the plurality of BMIC mounting circuits 221 to 224 may be connected to the battery module (e.g., module 114) disposed at the outermost side of the battery modules 111 to 114 corresponding to the CMC 200. The mounting circuit (e.g., circuit 224) disposed at one outermost side of the plurality of BMIC mounting circuits 221 to 224 may or may not have the BMIC 234 mounted thereon, depending on the number and configurations of the plurality of battery modules 111 to 114 and 121 to 123.

The CMC 300 may include two terminals P31_1 and P31_2, a plurality of BMIC mounting circuits 321 to 324, a plurality of BMICs 331 to 334, a connection module 340, and a plurality of wirings LN31 to LN34. The plurality of BMIC mounting circuits 321 to 324 may indicate the plurality of circuits including a plurality of vias formed to mount the respective BMICs and the plurality of terminals connected to the plurality of battery cells. The two terminals P31_1 and P31_2 may be terminals formed to allow the CMC 300 to be connected to the MBMS 300 and at least one remaining CMC 200 among the plurality of CMCs 200 and 300 in the daisy chain manner.

Hereinafter, the number of the plurality of BMIC mounting circuits 321 to 324 is described as being four, which is described only for the convenience of description, and the present disclosure is not limited thereto. The CMC 300 may include the plurality of BMIC mounting circuits depending on the number of corresponding modules 121 to 123 among the plurality of battery modules 111 to 114 and 121 to 123.

Each of the plurality of BMIC mounting circuits 321 to 324 (e.g., circuit 321) may have its corresponding BMIC (e.g., BMIC 331) among the plurality of BMICs 331 to 334. Each of the plurality of BMIC mounting circuits 321 to 324 (e.g., circuit 321) may provide the electrical connection between the plurality of battery cells included in its corresponding battery module (e.g., module 121) among the plurality of battery modules 121 to 123 and its corresponding BMIC (e.g., BMIC 331) among the plurality of BMICs 331 to 334. When three BMICs 331 to 333 are electrically connected to the remaining mounting circuits (e.g., circuits 321 to 323) except for the mounting circuit (e.g., circuit 324) disposed at one outermost side of the plurality of BMIC mounting circuits 321 to 324, each of the three BMICs 331 to 333 (e.g., BMIC 331) may be connected to both ends of its corresponding battery module (e.g., module 121) among the plurality of battery modules 121 to 123. In detail, each of the plurality of BMICs 331 to 333 (e.g., BMIC 331) may be connected to both ends of each of the plurality of battery cells included in its corresponding battery module (e.g., module 121).

The plurality of BMIC mounting circuits 321 to 324 may be connected with each other in the daisy chain manner. The BMIC mounting circuit 321 may be electrically connected to the terminal P31_1 and electrically connected to the BMIC mounting circuit 322. The BMIC mounting circuit 322 may be electrically connected to the BMIC mounting circuit 323. The BMIC mounting circuit 323 may be electrically connected to the connection module 340 via the wiring LN31. The BMIC mounting circuit 324 may be electrically connected to the connection module 340 via the wiring LN32 and the wiring LN33. The connection module 340 may be electrically connected to the terminal P31_2 via the wiring LN34. The wirings formed inside the CMC 300, described below, may be implemented as an internal wiring (trace) on the board on which the CMC 300 is implemented.

Each (e.g., BMIC 331) of the remaining circuits (e.g., circuits 321 to 323) except for the mounting circuit (e.g., circuit 324) disposed at one outermost side of the plurality of BMIC mounting circuits 321 to 324 may be connected to both the ends of each of the plurality of battery cells included in its corresponding battery module (e.g., module 121) among the plurality of battery modules 121 to 123. The BMIC 331 may receive a signal indicating the voltage across each of the plurality of battery cells included in the battery module 121, and derive the cell voltage of each of the plurality of battery cells included in the battery module 121. The BMIC 332 may receive a signal indicating the voltage across each of the plurality of battery cells included in the battery module 122, and derive the cell voltage of each of the plurality of battery cells included in the battery module 122. The BMIC 333 may receive a signal indicating the voltage across each of the plurality of battery cells included in the battery module 123, and derive the cell voltage of each of the plurality of battery cells included in the battery module 123.

The plurality of BMICs 331 to 333 electrically connected to the remaining circuits (e.g., circuits 321 to 323) except for the mounting circuit (e.g., circuit 324) disposed at one outermost side of the plurality of BMIC mounting circuits 321 to 324 and may communicate with each other in the daisy chain manner. The BMIC 331 disposed at one end of the plurality of BMICs 331 to 333 may communicate with the terminal P31_1 to thus transmit and receive the signal and/or the data. The BMIC 331 may communicate with the BMIC 332 to thus transmit and receive the signal and/or the data. The BMIC 332 may communicate with the BMIC 333 to thus transmit and receive the signal and/or the data. The BMIC 333 may communicate with the BMIC 334 to thus transmit and receive the signal and/or the data.

The mounting circuit (e.g., circuit 324) disposed on one outermost side of the plurality of BMIC mounting circuits 321 to 324 may not be connected to the battery module because there is no corresponding battery module among the battery modules 121 to 123 corresponding to the CMC 300. As described above, the mounting circuit (e.g., circuit 324) disposed at one outermost side of the plurality of BMIC mounting circuits 321 to 324 may or may not have the BMIC 334 mounted thereon.

FIG. 1 shows that the BMIC 234 is mounted on the BMIC mounting circuit 224 and the BMIC 334 is not mounted on the BMIC mounting circuit 324, which is described for the convenience of description, and the present disclosure is not limited thereto. The following description describes an embodiment in which the BMIC 234 is mounted on the BMIC mounting circuit 224 via the CMC 200, and another embodiment in which the BMIC 334 is not mounted on the BMIC mounting circuit 324 via the CMC 300.

The MBMS 400 may include a connector 401. The connector 401 may be connected to and communicate with the CMCs 200 and 300 in the daisy chain manner. The connector 401 may be connected to the terminal P21_1 via the wiring. The terminal P21_2 may be connected to the terminal P31_1. The terminal P31_2 may be connected to the connector 401. The connector 401 and the terminal P21_1, the terminal P21_2 and the terminal P31_1, and the terminal P31_2 and the connector 401 may each be connected via an external wiring (wireharness).

Each of the plurality of CMCs 200 and 300 (e.g., CMC 200) may provide a power path for its connection and communication with the BMIC mounting circuit (e.g., circuits 221 to 224) having the BMIC mounted thereon among the plurality of BMIC mounting circuits (e.g., circuits 221 to 224) in the daisy chain manner in each of cases where the BMIC is mounted or not mounted on each of the two BMIC mounting circuits 224 and 324. Each of the plurality of CMCs 200 and 300 (e.g., CMC 200) may include the connection module (e.g., 240) for providing the power path.

FIG. 1 shows that the CMC 200 includes the connection module 240 connected to the BMIC mounting circuit 224, which is one of the outermost sides of the plurality of BMIC mounting circuits 221 to 224, and the CMC 300 includes the connection module 340 connected to the BMIC mounting circuit 324, which is one of the outermost sides of the plurality of BMIC mounting circuits 321 to 324, which is described for the convenience of description, and the present disclosure is not limited thereto. Each of the plurality of CMCs 200 and 300 may include at least one connection module.

In some embodiments, the CMC may include a first connection module connected to the BMIC mounting circuit (e.g., circuit 224) disposed at one outermost side of the plurality of BMIC mounting circuits (e.g., circuits 221 to 224) and a second connection module connected to the BMIC mounting circuit (e.g., circuit 221) disposed at the other outermost side of the plurality of BMIC mounting circuits (e.g., circuits 221 to 224). In another embodiment, the connection module of the CMC may be connected to the BMIC mounting circuit (e.g., circuit 221) disposed at the other outermost side of the plurality of BMIC mounting circuits (e.g., circuits 221 to 224).

The connection module 240 may be connected to the BMIC mounting circuit 224 disposed at one outermost side of the plurality of BMIC mounting circuits 221 to 224, the BMIC mounting circuit 223 adjacent to the BMIC mounting circuit 224 disposed at one outermost side of the plurality of BMIC mounting circuits 221 to 224, and the terminal P21_2. The connection module 240 may be connected to the BMIC mounting circuit 223 via the wiring LN21. The connection module 240 may be connected to the BMIC mounting circuit 224 via the wiring LN21 and the wiring LN23. The connection module 240 may be connected to the terminal P21_2 via the wiring LN24.

The connection module 240 may connect the remaining three BMIC mounting circuits 221 to 223 with each other in the daisy chain manner, except for the BMIC mounting circuit 224 disposed at one outermost side of the plurality of BMIC mounting circuits 221 to 224, via the power path including the wiring LN21 and the wiring LN24. Alternatively, the connection module 240 may connect the four BMIC mounting circuits 221 to 224 with each other in the daisy chain manner via the power path including the wiring LN21, the wiring LN22, the wiring LN23, and the wiring LN24.

The connection module 340 may be connected to the BMIC mounting circuit 324 disposed at one outermost side of the plurality of BMIC mounting circuits 321 to 324, the BMIC mounting circuit 323 adjacent to the BMIC mounting circuit 324 disposed at one outermost side of the plurality of BMIC mounting circuits 321 to 324, and the terminal P21_2. The connection module 340 may be connected to the BMIC mounting circuit 323 via the wiring LN31. The connection module 240 may be connected to the BMIC mounting circuit 324 via the wiring LN32 and the wiring LN32. The connection module 340 may be connected to the terminal P31_2 via the wiring LN34.

The connection module 340 may connect the remaining three BMIC mounting circuits 321 to 323 with each other in the daisy chain manner, except for the BMIC mounting circuit 324 disposed at one outermost side of the plurality of BMIC mounting circuits 321 to 324, via the power path including the wiring LN31 and the wiring LN34. Alternatively, the connection module 340 may connect the four BMIC mounting circuits 321 to 324 with each other in the daisy chain manner via the power path including the wiring LN31, the wiring LN32, the wiring LN33, and the wiring LN34.

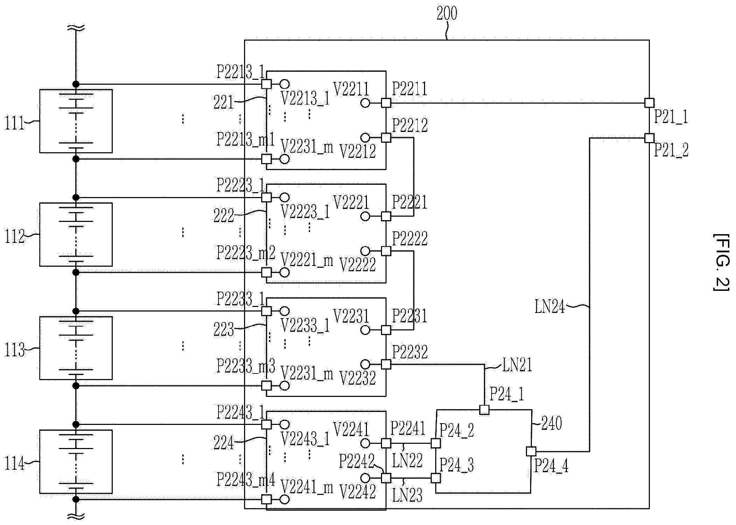

FIG. 2 is a block diagram schematically showing a board of one of two cell module controllers (CMCs) shown in FIG. 1.

Referring to FIG. 2, one of the two terminals P21_1 and P21_2 (e.g., terminal P21_1) may be connected to the MBMS 401 via the wiring, and the other of the two terminals P21_1 and P21_2 (e.g., terminal P21_2) may be connected to the terminal (e.g., terminal P31_1) of another CMC (e.g., CMC 300 in FIG. 1) via the wiring. The terminal P21_2 may be connected to one end of the wiring LN24.

The BMIC mounting circuit 221 may include a plurality of connection terminals P2211, P2212, and P2213_1 to P2213_m1 and a plurality of vias V2211, V2212, and V2213_1 to V2213_m1. Here, m1 may be a natural number greater than or equal to 3. Each of the plurality of vias V2211, V2212, and V2213_1 to V2213_m1 may include a via hole in which each chip pin of the BMIC is mounted. In the BMIC 231 shown in FIG. 1, the chip pins of BMIC 231 may be plugged into the plurality of vias V2211, V2212, and V2213_1 to V2213_m1 and mounted on the BMIC mounting circuit 221.

Each of the plurality of vias V2213_1 to V2213_m1 (e.g., via V2213_1) may be electrically connected to its corresponding connection terminal (e.g., terminal P2213_1) among the plurality of connection terminals (terminals P2213_1 to P2213_m1). The connection terminals P2213_1 to P2213_m1 connected to the battery module 111 may be connected to both the ends of each of the plurality of battery cells connected in series and included in the battery module 111.

The via V2211 may be electrically connected to the connection terminal P2211. The connection terminal P2211 may be connected to the terminal P21_1 via the wiring. The via V2212 may be electrically connected to the connection terminal P2212.

The BMIC mounting circuit 222 may include a plurality of connection terminals P2221, P2222, and P2223_1 to P2223_m2 and a plurality of vias V2221, V2222, and V2223_1 to V2223_m2. Here, m2 may be a natural number greater than or equal to 3. Each of the plurality of vias V2221, V2222, and V2223_1 to V2223_m2 may include a via hole in which each chip pin of the BMIC is mounted. In the BMIC 232 shown in FIG. 1, the chip pins of BMIC 232 may be plugged into the plurality of vias V2221, V2222, and V2223_1 to V2223_m2 and mounted on the BMIC mounting circuit 222.

Each of the plurality of vias V2223_1 to V2223_m2 (e.g., via V2223_1) may be electrically connected to its corresponding connection terminal (e.g., terminal P2223_1) among the plurality of connection terminals (terminals P2223_1 to P2223_m2). The connection terminals P2223_1 to P2223_m2 connected to the battery module 112 may be connected to both ends of each of the plurality of battery cells connected in series and included in the battery module 112.

The via V2221 may be electrically connected to the connection terminal P2221. The connection terminal P2221 may be connected to the connection terminal P2212 of the BMIC mounting circuit 221 via the wiring. The via V2222 may be electrically connected to the connection terminal P2222.

The BMIC mounting circuit 223 may include a plurality of connection terminals P2231, P2232, and P2233_1 to P2233_m3 and a plurality of vias V2231, V2232, and V2233_1 to V2233_m3. Here, m3 may be a natural number greater than or equal to 3. Each of the plurality of vias V2231, V2232, and V2233_1 to V2233_m3 may include a via hole in which each chip pin of the BMIC is mounted. In the BMIC 233 shown in FIG. 1, the chip pins of BMIC 232 may be plugged into the plurality of vias V2231, V2232, and V2233_1 to V2233_m3 and mounted on the BMIC mounting circuit 223.

Each of the plurality of vias V2233_1 to V2233_m3 (e.g., via V2233_1) may be electrically connected to its corresponding connection terminal (e.g., terminal P2233_1) among the plurality of connection terminals (terminals P2233_1 to P2233_m3). The connection terminals P2223_1 to P2223_m3 connected to the battery module 113 may be connected to both ends of each of the plurality of battery cells connected in series and included in the battery module 113.

The via V2231 may be electrically connected to the connection terminal P2231. The connection terminal P2231 may be connected to the connection terminal P2222 of the BMIC mounting circuit 222 via the wiring. The via V2232 may be electrically connected to the connection terminal P2232. The connection terminal P2232 may be connected to one end of the wiring LN21.

The BMIC mounting circuit 224 may include a plurality of connection terminals P2241, P2242, and P2243_1 to P2243_m4 and a plurality of vias V2241, V2242, and V2243_1 to V2243_m4. Here, m4 may be a natural number greater than or equal to 3. Each of the plurality of vias V2241, V2242, and V2243_1 to V2243_m4 may include a via hole in which each chip pin of the BMIC is mounted. In the BMIC 234 shown in FIG. 1, the chip pins of BMIC 234 may be plugged into the plurality of vias V2241, V2242, and V2243_1 to V2243_m4 and mounted on the BMIC mounting circuit 224.

Each of the plurality of vias V2243_1 to V2243_m3 (e.g., via V2243_1) may be electrically connected to its corresponding connection terminal (e.g., terminal P2243_1) among the plurality of connection terminals (terminals P2243_1 to P2243_m4). The connection terminals P2233_1 to P2233_m4 connected to the battery module 113 may be connected to both the ends of each of the plurality of battery cells connected in series and included in the battery module 113.

The via V2241 may be electrically connected to the connection terminal P2241. The connection terminal P2241 may be connected to one end of the wiring LN22. The via V2242 may be electrically connected to the connection terminal P2242. The connection terminal P2242 may be connected to one end of the wiring LN23.

The connection module 240 may provide electrical connections among the BMIC mounting circuit (e.g., circuit 224) disposed at one outermost side of the plurality of BMIC mounting circuits 221 to 224, the BMIC mounting circuit (e.g., circuit 223) adjacent to the BMIC mounting circuit (e.g., circuit 224) disposed at the one outermost side, and the terminal P21_2. The connection module 240 may include a plurality of terminals P24_1 to P24_4.

The terminal P24_1 may be connected to the other end of the wiring LN21, the terminal P24_2 may be connected to the other end of the wiring LN22, the terminal 24_3 may be connected to the other end of the wiring LN23, and the terminal P24_4 may be connected to the other end of the wiring LN24_4.

When the BMIC is electrically connected to the BMIC mounting circuit (e.g., circuit 224) disposed at one outermost side of the plurality of BMIC mounting circuits 221 to 224, the connection module 240 may provide a connection between the BMIC mounting circuit (e.g., circuit 223) adjacent to the BMIC mounting circuit (e.g., circuit 224) disposed at the one outermost side and the terminal P21_2 via the wiring LN21 and the wiring LN24.

When the BMIC (e.g., BMIC 234 in FIG. 1) is electrically connected to the BMIC mounting circuit (e.g., 224) disposed at one outermost side of the plurality of BMIC mounting circuits 221 to 224, the connection module 240 may provide connections between the BMIC mounting circuit (e.g., circuit 224) disposed at one outermost side and the BMIC mounting circuit (e.g., circuit 223) adjacent to the BMIC mounting circuit (e.g., circuit 224) disposed at the one outermost side via the wiring LN21 and the wiring LN22, and between the BMIC mounting circuit (e.g., circuit 224) disposed at the one outermost side and the terminal P21_2 via the wiring LN23 and the wiring LN24.

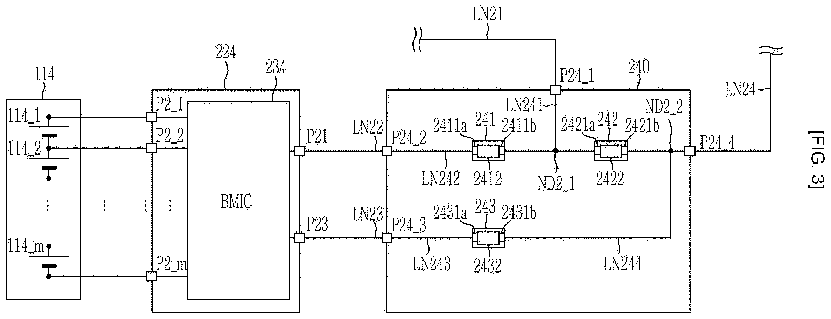

FIG. 3 is a block diagram schematically showing a detailed configuration of one of two connection modules shown in FIG. 1.

Referring to FIG. 3, the battery module 114 may include a plurality of battery cells 114_1 to 114_m4 connected in series. Here, m4 is a natural number greater than or equal to 3. The BMIC mounting circuit 224 may include a plurality of terminals P2_1 to P2_m4, P21, and P22.

Both ends of each of the plurality of battery cells 114_1 to 114_m may be connected to each of the plurality of terminals P2_1 to P2_m4. The plurality of terminals P2_1 to P2_m may be connected to the BMIC 234. The BMIC 234 may derive the voltage across each of the plurality of battery cells 114_1 to 114_m based on signals received from the plurality of terminals P2_1 to P2_m. The two terminals P21 and P22 may be connected to the BMIC 234.

The connection module 240 may include the plurality of terminals P24_1 to P24_4 and a plurality of resistor mounting circuits 241 to 243. The wiring LN21 may have one end connected to the terminal of the BMIC mounting circuit 223 shown in FIGS. 1 and 2 (e.g., terminal P2232 shown in FIG. 2) and the other end connected to the terminal P24_1. The wiring LN24 may have one end connected to the terminal P21_2 shown in FIGS. 1 and 2 and the other end connected to the terminal P24_4. The wiring LN22 may have one end connected to the terminal P21 and the other end connected to the terminal P24_2. The wiring LN23 may have one end connected to the terminal P22 and the other end connected to the terminal P24.

Each of the plurality of resistor mounting circuits 241 to 243 may be a region formed to allow the resistor to be electrically connected between its both ends. The resistor mounting circuit 241 may include both ends 2411a and 2411b and a mounting region 2412. The resistor mounting circuit 242 may include both ends 2421a and 2421b and a mounting region 2422. The resistor mounting circuit 243 may include both ends 2431a and 2431b and a mounting region 2432. When the resistor is connected between both the ends of each of the plurality of resistor mounting circuits 241 to 243, an electrical connection may be provided between both the ends to which the resistor is connected.

Each of the resistors mounted on the plurality of resistor mounting circuits 241 to 243, described below, may have a resistor value less than a predetermined reference resistor. For example, in an embodiment, the reference resistor may be 0.02 ohm, and the resistor mounting circuit may have a resistor referred to as a "0 ohm resistor", having a resistor value less than 0.02 ohm and mounted thereon.

Each of the plurality of mounting regions 2412, 2422, and 2432 may or may not have the resistor mounted thereon. When no resistor is mounted on each of the plurality of mounting regions 2412, 2422, and 2432 (e.g., region 2412), the corresponding resistor mounting circuit (e.g., circuit 241) among the plurality of resistor mounting circuits 241 to 243 may be open between both the ends (e.g., ends 2411a and 2411b).

The resistor mounting circuit 241 may be a circuit for providing an electrical connection between the terminal P24_1 and the terminal P24_2. The resistor mounting circuit 241 may have one end 2411a connected to the terminal P24_2 via a wiring LN242. The resistor mounting circuit 241 may have the other end 2411b connected to a node ND2_1 via a wiring LN241. The node ND2_1 may be a node on the wiring LN241 connected to the terminal P24_1. When the resistor is electrically connected between one end 2411a and the other end 2411b of the resistor mounting circuit 241, the connection module 240 may provide the electrical connection between the terminal P24_1 and the terminal P24_2. When no resistor is electrically connected between one end 2411a and the other end 2411b of the resistor mounting circuit 241, the resistor mounting circuit 241 may be open between one end 2411a and the other end 2411b.

The resistor mounting circuit 242 may be a circuit for providing an electrical connection between the terminal P24_1 and the terminal P24_4. The resistor mounting circuit 242 may have one end 2421a connected to the node ND2_1. The resistor mounting circuit 242 may have the other end 2421b connected to a node ND2_2. The node ND2_2 may be a node on a wiring LN244 connected to the terminal P24_4. When the resistor is electrically connected between one end 2421a and the other end 2421b of the resistor mounting circuit 242, the connection module 240 may provide the electrical connection between the terminal P24_1 and the terminal P24_4. When no resistor is electrically connected between one end 2421a and the other end 2421b of the resistor mounting circuit 242, the resistor mounting circuit 242 may be open between one end 2421a and the other end 2421b.

The resistor mounting circuit 243 may be a circuit for providing an electrical connection between the terminal P24_3 and the terminal P24_4. The resistor mounting circuit 243 may have one end 2431a connected to the terminal P24_3 via a wiring LN243. The resistor mounting circuit 243 may have the other end 2431b connected to the node ND2_2 via a wiring LN244. When the resistor is electrically connected between one end 2431a and the other end 2431b of the resistor mounting circuit 243, the connection module 240 may provide the electrical connection between the terminal P24_3 and the terminal P24_4. When no resistor is electrically connected between one end 2431a and the other end 2431b of the resistor mounting circuit 243, the resistor mounting circuit 243 may be open between one end 2431a and the other end 2431b.

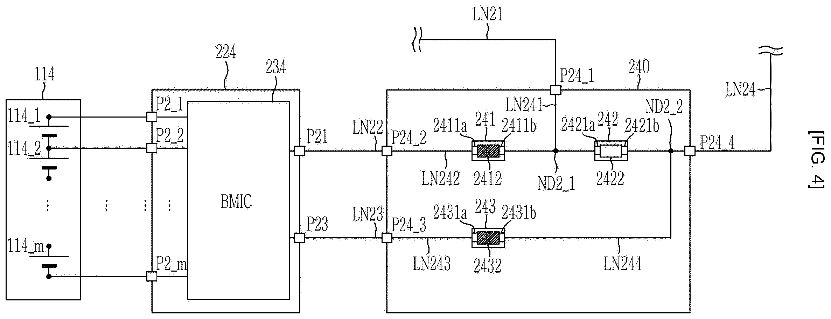

FIG. 4 is a block diagram showing a state where the resistors are mounted on two of the plurality of resistor mounting circuits shown in FIG. 3.

Referring to FIG. 4, a resistor R may be mounted between both the ends (e.g., ends 2421a and 2421b) of each (e.g., resistor 241) of the two resistor mounting circuits 241 and 243. When the resistor R is mounted on each of the two resistor mounting circuits 241 and 243, the power path may be formed, which includes the wiring LN21, the terminal P24_1, the wiring LN241 (and the node ND2_1), the resistor mounting circuit 241, the wiring LN242, the terminal P24_2, the wiring LN22, the terminal P21, the BMIC 234, the terminal P22, the wiring LN23, the terminal P24_3, the wiring LN243, the resistor mounting circuit 243, the wiring LN244 (and the node ND2_2), the terminal P24_4, and the wiring LN24. The resistor mounting circuit 242 may not have the resistor mounted thereon, and the circuit may thus be open between both the ends 2421a and 2421b, thereby preventing any current from flowing.

Referring to FIGS. 1 and 4, the plurality of BMIC mounting circuits 221 to 224, each electrically connected to the BMIC, may be connected in the daisy chain manner via the power path including the wiring LN21, the terminal P24_1, the wiring LN241 (and the node ND2_1), the resistor mounting circuit 241, the wiring LN242, the terminal P24_2, the wiring LN22, the terminal P21, the BMIC 234, the terminal P22, the wiring LN23, the terminal P24_3, the wiring LN243, the resistor mounting circuit 243, the wiring LN244 (and the node ND2_2), the terminal P24_4, and the wiring LN24.

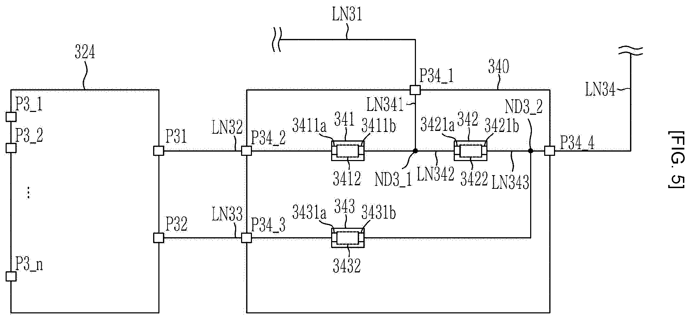

FIG. 5 is a block diagram schematically showing a detailed configuration of the connection module connected to the battery monitoring integrated circuit (BMIC) mounting circuit not having the BMIC mounted thereon among the connection module shown in FIG. 1.

Referring to FIG. 5, the BMIC mounting circuit 224 may include a plurality of terminals P3_1 to P3_n, P31, and P32. Here, n is a natural number greater than or equal to 3. The BMIC mounting circuit 324 may not have the BMIC mounted thereon.

The connection module 340 may include a plurality of terminals P34_1 to P34_4 and a plurality of resistor mounting circuits 341 to 343. The wiring LN31 may have one end connected to the BMIC 333 shown in FIG. 1 and the other end connected to the terminal P34_1. The wiring LN2 may have one end connected to the terminal P31_2 shown in FIG. 1 and the other end connected to the terminal P34_4. The wiring LN32 may have one end connected to the terminal P31 and the other end connected to the terminal P34_2. The wiring LN33 may have one end connected to the terminal P32 and the other end connected to the terminal P34_3.

Each of the plurality of resistor mounting circuits 341 to 343 may be a region formed to allow the resistor to be mounted between both ends of the circuit. The resistor mounting circuit 341 may include both ends 3411a and 3411b and a mounting region 3412. The resistor mounting circuit 342 may include both ends 3421a and 3421b and a mounting region 3422. The resistor mounting circuit 343 may include both ends 3431a and 3431b and a mounting region 3432.

Each of the resistors mounted on the plurality of resistor mounting circuits 341 to 343, described below, may have the resistor value less than the predetermined reference resistor. For example, in an embodiment, the reference resistor may be 0.02 ohm, and the resistor mounting circuit may have the resistor referred to as the "0 ohm resistor", having the resistor value less than 0.02 ohm and mounted thereon.

Each of the plurality of mounting regions 3412, 3422, and 3432 may or may not have the resistor mounted thereon. When no resistor is mounted on each of the plurality of mounting regions 3412, 3422, and 3432 (e.g., region 3412), the corresponding resistor mounting circuit (e.g., circuit 341) among the plurality of resistor mounting circuits 341 to 343 may be open between both the ends (e.g., ends 3411a and 3411b).

The resistor mounting circuit 341 may be a circuit for providing an electrical connection between the terminal P34_1 and the terminal P34_2. The resistor mounting circuit 341 may have one end 3411a connected to the terminal P34_2. The resistor mounting circuit 341 may have the other end 3411b connected to a node ND3_1. The node ND3_1 may be a node on a wiring LN341 connected to the terminal P34_1. When the resistor is electrically connected between one end 3411a and the other end 3411b of the resistor mounting circuit 341, the connection module 340 may provide the electrical connection between the terminal P34_1 and the terminal P34_2. When no resistor is electrically connected between one end 3411a and the other end 3411b of the resistor mounting circuit 341, the resistor mounting circuit 341 may be open between one end 3411a and the other end 3411b.

The resistor mounting circuit 342 may be a circuit for providing an electrical connection between the terminal P34_1 and the terminal P34_4. The resistor mounting circuit 342 may have one end 3421a connected to the node ND3_1 via a wiring LN342. The resistor mounting circuit 342 may have the other end 2431b connected to a node ND3_2 via a wiring LN343. The node ND3_2 may be a node on the wiring LN343 connected to the terminal P34_4. When the resistor is electrically connected between one end 3421a and the other end 3421b of the resistor mounting circuit 342, the connection module 340 may provide the electrical connection between the terminal P34_1 and the terminal P34_4. When no resistor is electrically connected between one end 3421a and the other end 3421b of the resistor mounting circuit 342, the resistor mounting circuit 342 may be open between one end 3421a and the other end 3411b.

The resistor mounting circuit 343 may be a circuit for providing an electrical connection between the terminal P34_3 and the terminal P34_4. The resistor mounting circuit 343 may have one end 3431a connected to the terminal P34_3. The resistor mounting circuit 343 may have the other end 3431b connected to the node ND3_2. When the resistor is electrically connected between one end 3431a and the other end 3431b of the resistor mounting circuit 343, the connection module 340 may provide the electrical connection between the terminal P34_3 and the terminal P34_4. When no resistor is electrically connected between one end 3431a and the other end 3431b of the resistor mounting circuit 343, the resistor mounting circuit 343 may be open between one end 3431a and the other end 3431b.

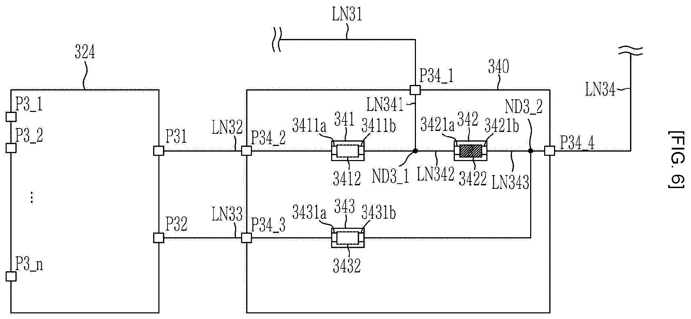

FIG. 6 is a block diagram showing a state where the resistor is mounted on one of the plurality of resistor mounting circuits shown in FIG. 5.

Referring to FIG. 6, the resistor R may be mounted between both the ends 3421a and 3421b of the resistor mounting circuit 342. When the resistor R is mounted on the resistor mounting circuit 342, the power path may be formed, which includes the wiring LN31, the terminal P34_1, the wiring LN341, the node ND3_1, the wiring LN342, the resistor mounting circuit 342, the wiring LN343 (the node ND3_2), the terminal P34_4, and the wiring LN34. Each of the two resistor mounting circuits 341 and 343 (e.g., circuit 341) may not have the resistor mounted thereon, and the circuit may thus be open between both the ends 3421a and 3421b, thereby preventing any current from flowing.

Referring to FIGS. 1 and 6, the three BMIC mounting circuits 321 to 323 electrically connected to the BMIC among the plurality of BMIC mounting circuits 321 to 324 may be connected in the daisy chain manner through the power path including the wiring LN31, the terminal P34_1, the wiring LN341, the node ND3_1, the wiring LN342, the resistor mounting circuit 342, the wiring LN343 (and the node ND3_2), the terminal P34_4, and the wiring LN34.

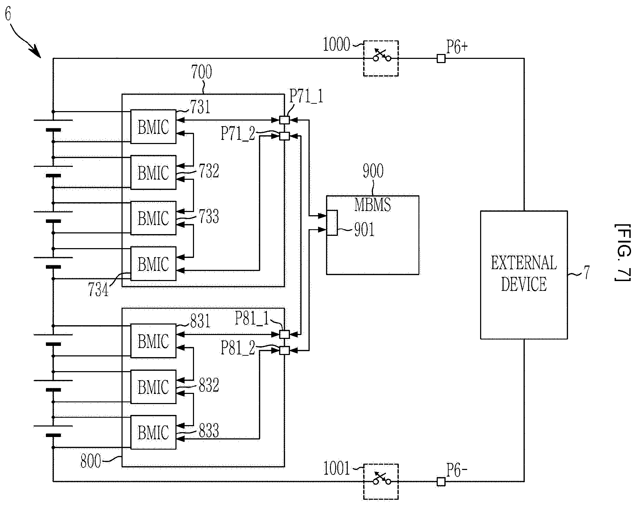

FIG. 7 is an example diagram of a comparison circuit not including the connection module.

As an example of the battery system, a comparison circuit 6 shown in FIG. 7 may include a plurality of battery modules 611 to 614 and 621 to 623, a plurality of CMCs 700 and 800, a MBMS 900, and relays 1000 and 1001. Both ends P6+ and P6- of the comparison circuit 6 may be connected to an external device 7.

The CMC 700 may include two terminals P71_1 and P71_2 and four BMICs 731 to 734, and the CMC 800 may include two terminals P81_1 and P81_2 and three BMICs 831 to 833. The four BMICs 731 to 734 may be connected to the four battery modules 611 to 614, and the three BMICs 831 to 833 may be connected to the three battery modules 621 to 623. Each of the four BMICs 731 to 734 and the three BMICs 831 to 833 may be electrically connected to a circuit corresponding to a BMIC mounting circuit according to an embodiment.

The two terminals P71_1 and P71_2 may be connected to and communicate with the four BMICs 731 to 734 in the daisy chain manner via an internal wiring, and the two terminals P81_1 and P81_2 may be connected to and communicate with the three BMICs 831 to 833 in the daisy chain manner via the internal wiring. In this way, the two CMCs 700 and 800 may respectively include different numbers of BMICs, and the two CMCs 700 and 800 may thus have different types of internal wiring. According to the comparison circuit 6, the CMCs 700 and CMC 800 may be implemented on different boards.

The MBMS 900 may include a connector 901. The connector 901 may be connected to and communicate with the CMCs 700 and 800 in the daisy chain manner. The connector 901 may be connected to the terminal P71_1 via the wiring. The terminal P71_2 may be connected to the terminal P81_1. The terminal P81_2 may be connected to the connector 901. The connector 901 and the terminal P71_1, the terminal P71_2 and the terminal P81_1, and the terminal P81_2 and the connector 901 may each be connected via an external wiring (wireharness).

As described above, the CMC may require various applications for different CMC types depending on the battery configuration, and each battery pack may require the implementation of up to tens of CMCs. In a project that requires such a variety of CMCs, each CMC may use different printed circuit boards and bills of materials (BOMs), which may require individual master data management (MDM). As the battery pack uses more MDMs, its management may become difficult. Therefore, the battery system 1 according to an embodiment may have the connection module (e.g., module 240) included in each of the plurality of CMCs 200 and 300 (e.g., CMC 200), and thus be managed using the same printed circuit board, BOM, or the like.

Referring to FIG. 1, in the battery system 1 according to an embodiment, the BMIC mounting circuits 221 to 224 each having the BMIC mounted thereon and electrically connected to each other among the plurality of BMIC mounting circuits 221 to 224 disposed inside the CMC 200 may be connected to and communicate with each other in the daisy chain manner, and the BMIC mounting circuits 321 to 323 each having the BMIC mounted thereon and electrically connected to each other among the plurality of BMIC mounting circuits 221 to 224 disposed inside the CMC 300 may be connected to and communicate with each other in the daisy chain manner. As described above, although the two CMCs 200 and 300 respectively include the different numbers of BMICs, the CMCs may have the same type of internal wiring through the respective connection modules 240 and 340 and the plurality of wirings connected to the respective connection modules 240 and 340. Therefore, the two CMCs 200 and 300 may be implemented on the same printed circuit board. In the battery system 1, the plurality of CMCs 200 and 300 implemented on the same board may provide the different power paths through the connection modules 240 and 340 depending on whether the BMIC is mounted on each of the plurality of BMIC mounting circuits 224 and 324.

Although the embodiments of the present disclosure have been described in detail hereinabove, the scope of the present disclosure is not limited thereto. Various modifications and improvements made by those skilled in the art to which the present disclosure pertains also fall into the scope of the present disclosure.

## Claims

1. A printed circuit board (PCB) comprising:
a plurality of battery monitoring integrated circuit (BMIC) mounting circuits, each providing an electrical connection for its corresponding plurality of battery cells; and
a connection module providing electrical connections among a first BMIC mounting circuit disposed at one outermost side of the plurality of BMIC mounting circuits, a second BMIC mounting circuit adjacent to the first BMIC mounting circuit, and a first connection terminal,
wherein the first connection terminal is connected to a master battery management system (MBMS),
the connection module provides the connection between the second BMIC mounting circuit and the first connection terminal when a BMIC is not electrically connected to the first BMIC mounting circuit, and
the connection module provides the connections between the first connection terminal and the first BMIC mounting circuit and between the first BMIC mounting circuit and the second BMIC mounting circuit when a BMIC is electrically connected to the first BMIC mounting circuit.

2. The PCB of claim 1, wherein
the connection module includes
a first resistor mounting circuit having one end connected to a first terminal connected to the second BMIC mounting circuit via a first wiring, and the other end connected to a second terminal connected to the first BMIC mounting circuit via a second wiring, and
a second resistor mounting circuit having one end connected to a third terminal connected to the first BMIC mounting circuit via a third wiring, and the other end connected to a fourth terminal connected to the first connection terminal via a fourth wiring.

3. The PCB of claim 2, wherein
a resistor is electrically connected between the one end and the other end of the first resistor mounting circuit, and when the resistor is electrically connected between the one end and the other end of the second resistor mounting circuit,
the connection module provides
electrical connections between the first terminal and the second terminal and between the third terminal and the fourth terminal.

4. The PCB of claim 2, wherein
the connection module further includes
a third resistor mounting circuit having one end connected to the first terminal and the other end connected to the fourth terminal.

5. The PCB of claim 4, wherein
when a resistor is electrically connected between the one end and the other end of the third resistor mounting circuit,
the connection module provides
an electrical connection between the first terminal and the fourth terminal.

6. The PCB of claim 4, wherein
when no resistor is electrically connected between the one end and the other end of each of the first to third resistor mounting circuits,
each of the first to third resistor mounting circuits is open between its one end and the other end.

7. A battery system comprising:
a plurality of battery modules connected in series;
a plurality of cell module controllers (CMCs) connected to the plurality of battery modules; and
a master battery management system (MBMS) communicating with the plurality of CMCs in a daisy chain manner,
wherein each of the plurality of CMCs includes
a first connection terminal connected to the MBMS,
a plurality of battery monitoring integrated circuits (BMICs) each connected to each of the plurality of battery modules corresponding to the plurality of battery modules,
a first BMIC mounting circuit connected to the battery module disposed at one outermost side of the plurality of battery modules corresponding to the plurality of battery modules,
a second BMIC mounting circuit adjacent to the first BMIC mounting circuit and providing an electrical connection between its corresponding plurality of battery cells and a corresponding BMIC among the plurality of BMICs, and
a connection module providing electrical connections among the first BMIC mounting circuit, the second BMIC mounting circuit, and the MBMS,
the connection module provides a connection between the second BMIC mounting circuit and the MBMS when a BMIC is not electrically connected to the first BMIC mounting circuit, and
the connection module provides connections between the MBMS and the first BMIC mounting circuit and between the first BMIC mounting circuit and the second BMIC mounting circuit when a BMIC is electrically connected to the first BMIC mounting circuit.

8. The system of claim 7, wherein
the connection module includes
a first resistor mounting circuit having one end connected to a first terminal connected to the second BMIC mounting circuit via a first wiring, and the other end connected to a second terminal connected to the first BMIC mounting circuit via a second wiring, and
a second resistor mounting circuit having one end connected to a third terminal connected to the first BMIC mounting circuit via a third wiring, and the other end connected to a fourth terminal connected to the first connection terminal via a fourth wiring.

9. The system of claim 8, wherein
a resistor is electrically connected between the one end and the other end of the first resistor mounting circuit, and when the resistor is electrically connected between the one end and the other end of the second resistor mounting circuit,
the connection module provides
electrical connections between the first terminal and the second terminal and between the third terminal and the fourth terminal.

10. The system of claim 8, wherein
the connection module further includes
a third resistor mounting circuit having one end connected to the first terminal and the other end connected to the fourth terminal.

11. The system of claim 10, wherein
when a resistor is electrically connected between the one end and the other end of the third resistor mounting circuit,
the connection module provides
an electrical connection between the first terminal and the fourth terminal.

12. The system of claim 10, wherein
when no resistor is electrically connected between the one end and the other end of each of the first to third resistor mounting circuits,
each of the first to third resistor mounting circuits is open between its one end and the other end.
